(19) Europäisches Patentamt
European Patent Office
Office européen des brevets

(11) **EP 2 782 143 A1**

(12) **EUROPEAN PATENT APPLICATION**
published in accordance with Art. 153(4) EPC

(43) Date of publication:
**24.09.2014 Bulletin 2014/39**

(51) Int Cl.:
*H01L 31/068* (2012.01)   *H01L 31/032* (2006.01)
*H01L 31/0224* (2006.01)

(21) Application number: **12849880.5**

(22) Date of filing: **12.11.2012**

(86) International application number:
**PCT/JP2012/007227**

(87) International publication number:
**WO 2013/073149 (23.05.2013 Gazette 2013/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.11.2011   JP 2011251149**

(71) Applicant: **Kabushiki Kaisha Toshiba
Minato-ku
Tokyo 105-8001 (JP)**

(72) Inventors:
• **HIRAGA, Hiroki
Minato-ku, Tokyo 105-8001 (JP)**
• **SHIBASAKI, Soichiro
Minato-ku, Tokyo 105-8001 (JP)**

• **NAKAGAWA, Naoyuki
Minato-ku, Tokyo 105-8001 (JP)**
• **YAMAZAKI, Mutsuki
Minato-ku, Tokyo 105-8001 (JP)**
• **YAMAMOTO, Kazushige
Minato-ku, Tokyo 105-8001 (JP)**
• **SAKURADA, Shinya
Minato-ku, Tokyo 105-8001 (JP)**
• **INABA, Michihiko
Minato-ku, Tokyo 105-8001 (JP)**

(74) Representative: **HOFFMANN EITLE
Patent- und Rechtsanwälte
Arabellastrasse 4
81925 München (DE)**

(54) **PHOTOELECTRIC CONVERSION ELEMENT AND SOLAR CELL**

(57)   An aspect of one embodiment, there is provided a photoelectric conversion element, including a first electrode having optical transparency, a second electrode, and an optical absorption layer provided between the first electrode and the second electrode, the optical absorption layer having a compound semiconductor constituted with a chalcopyrite structure or a stannite structure, the compound semiconductor having a first element of a Group 11 element and a second element of a Group 16 element and comprising a p-type portion and an n-type portion provided between the p-type portion and the first electrode, the n-type portion and the p-type portion jointly having a homo junction, wherein the n-type portion comprises a dopant which has a formal charge $V_b$ being not less than 1.60 and not more than 2.83.

FIG.1

**Description**

<u>FIELD</u>

Exemplary embodiments described herein generally relate to a photoelectric conversion element and a solar cell.

<u>BACKGROUND</u>

A CIGS-system photoelectric conversion element having a compound semiconductor including Cu, In, Ga, S and Se used as an optical absorption layer has been proposed. Furthermore, a solar cell having the photoelectric conversion element has been demonstrated.

<u>PROBLEM AND SOLUTION</u>

Improvement of a photoelectric conversion efficiency of the CIGS-system photoelectric conversion element has been desired as a problem.

An aspect of one embodiment, there is provided a photoelectric conversion element, including a first electrode having optical transparency, a second electrode, and an optical absorption layer provided between the first electrode and the second electrode, the optical absorption layer having a compound semiconductor constituted with a chalcopyrite structure or a stannite structure, the compound semiconductor having a first element of a Group 11 element and a second element of a Group 16 element and comprising a p-type portion and an n-type portion provided between the p-type portion and the first electrode, the n-type portion and the p-type portion jointly having a homo junction, wherein the n-type portion comprises a dopant which has a formal charge $V_b$ being not less than 1.60 and not more than 2.83.

An aspect of another embodiment, there is provided a solar cell, including a photoelectric conversion element, including a first electrode having optical transparency, a second electrode, and an optical absorption layer provided between the first electrode and the second electrode, the optical absorption layer having a compound semiconductor constituted with a chalcopyrite structure or a stannite structure, the compound semiconductor having a first element of a Group 11 element and a second element of a Group 16 element and comprising a p-type portion and an n-type portion provided between the p-type portion and the first electrode, the n-type portion and the p-type portion jointly having a homo junction, wherein the n-type portion comprises a dopant which has a formal charge $V_b$ being not less than 1.60 and not more than 2.83, a substrate on which the photoelectric conversion element is stacked, a first terminal electrically connected to the first electrode, and a second terminal electrically connected to the second electrode.

<u>BRIEF DESCRIPTION OF THE DRAWINGS</u>

Fig.1 is a schematic cross-sectional view showing a photoelectric conversion element according to a first embodiment;

Fig.2 is a schematic cross-sectional view showing a photoelectric conversion element according to a second embodiment;

Fig.3 is a schematic cross-sectional view showing a solar cell according to a third embodiment;

Figs.4A-4D are schematic cross-sectional views showing a method for fabricating the solar cell according to the third embodiment;

Fig.5 is a flow chart showing processing steps in the method for fabricating the solar cell according to the third embodiment;

Fig.6 is a graph showing voltage-current characteristics according to sixth-eighth samples for an absorption layer;

Fig.7 is a graph showing characteristics of quantum efficiency of the sixth sample and the eighth sample for the absorption layer.

Figs.8A, 8B are schematic band diagrams showing a photoelectric conversion element according to a fourth embodiment;

Figs.9A-9F are schematic cross-sectional views showing photoelectric conversion elements of a first reference example and a second reference example;

Fig.10 is a schematic band diagram showing characteristics of a photoelectric conversion element according to a fifth embodiment;

Fig.11 is a graph showing characteristics of samples for the first-eighth electrodes;

Fig.12 is a graph showing characteristics of the samples for first-eighth electrodes;

Fig.13 is a graph showing characteristics of samples for ninth-eighteenth electrodes;

Fig.14 is a graph showing characteristics of the samples for the ninth-eighteenth electrodes;
Fig.15 is graph showing characteristics of samples for nineteenth-twenty-fourth electrodes;
Figs.16 is graph showing characteristics of the samples for the nineteenth-twenty-fourth electrodes.

## DETAILED DESCRIPTION

(First Embodiment)

Embodiments will be described below in detail with reference to the attached drawings mentioned above.

The drawings are schematically and conceptually represented, consequently, relations of thickness, width or the like in each of portions are not restricted to real ones. Further, each of size, ratio or the like is represented in a different fashion even when the same portion is drawn. Throughout the attached drawings, similar or same reference numerals show similar, equivalent or same components, and the description is not repeated.

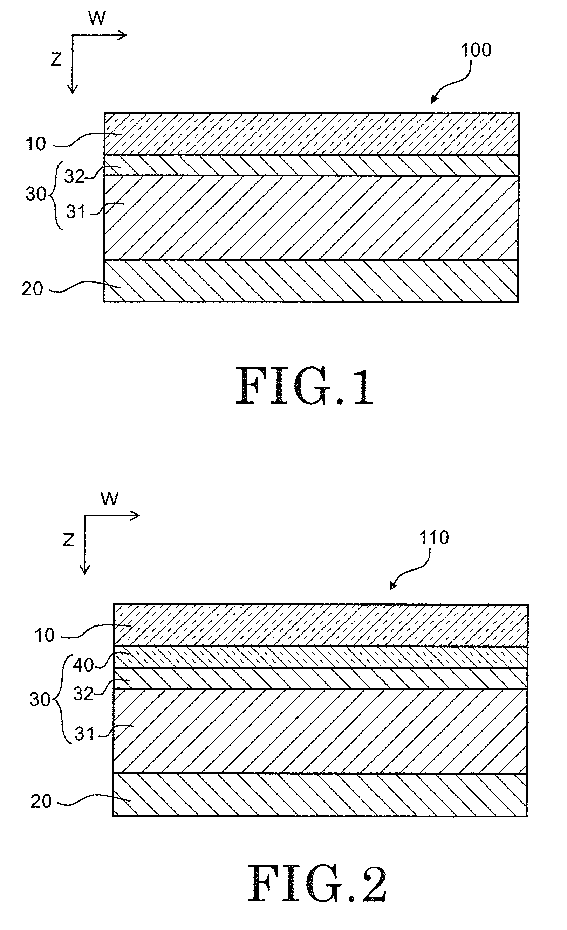

Fig.1 is a schematic cross-sectional view showing a constitution of a photoelectric conversion element according to a first embodiment. As shown in Fig.1, a photoelectric conversion element 100 includes a first electrode 10, a second electrode 20 and an optical absorption layer 30.

A metal compound having optical transparency and conductivity is employed as the first electrode 10. An intermetallic compound, for example, ZnO:Al, ZnO:B, or the like is used as the first electrode 10. A metal material having conductivity is employed as the second electrode 20. The metal material, for example, Molybdenum or the like is used as the second electrode 20.

The optical absorption layer 30 is provided between the first electrode 10 and the second electrode 20. One surface of the optical absorption layer 30 is contacted to the first electrode 10. The other surface of the optical absorption layer 30 is contacted to the second electrode 20.

The optical absorption layer 30 absorbs light entered into the optical absorption layer 30. Electromotive force corresponding to an amount of the absorbed light is generated in the optical absorption layer 30. The optical absorption layer 30 includes a photoelectric conversion function which converts light into electrical signal. A compound semiconductor having a chalcopyrite structure is employed as the optical absorption layer 30.

As shown in Fig.1, a thickness direction from the first electrode 10 to the second electrode 20 is defined as Z-direction. One direction in perpendicular direction to the Z-direction is defined as W-direction.

Light is entered into the first electrode 10 from the opposed surface to a surface of the first electrode contacted to the optical absorption layer 30. The incident light is transmissive in the first electrode 10 and is entered into the optical absorption layer 30.

The optical absorption layer 30 absorbs the transmitted light in the first electrode 10 to generate the electromotive force. The electromotive force generated in the optical absorption layer 30 is derived into an outer portion via the first electrode 10 or the second electrode 20. In the photoelectric conversion element 100, the electromotive force generated by the optical absorption layer 30 can be derived in the first electrode 10 and the second electrode 20.

The optical absorption layer 30 includes a p-type portion 31 and an n-type portion 32. The p-type portion 31 is contacted to the second electrode 20, for example. The n-type portion 32 is provided between the p-type portion 31 and the first electrode 10. The optical absorption layer 30 is firstly provided as a p-type semiconductor layer. A portion of the p-type semiconductor layer at a side of the first electrode 10 is transformed into an n-type semiconductor layer so that the n-type portion 32 is provided at the side of the first electrode 10 of the optical absorption layer 30. As a result, a portion of the p-type semiconductor layer other than the n-type portion 32 is remained as the p-type portion 31. In such a manner, the p-type portion 31 and the n-type portion 32 are jointly provided with a homo junction in the optical absorption layer 30. Photoelectric conversion function of the optical absorption layer 30 is obtained by the p-n junction between the p-type portion 31 and the n-type portion 32.

Immersion, for example, is applied to transformation of the p-type semiconductor layer into the n-type portion 32. An arbitrary approach, for example, dipping, spray-coating or the like in which liquid is contacted to a processing body, is included in the immersion. When the n-type portion 32 is provided by using doping Cd as an n-type dopant, for example, a processing body having a p-type semiconductor layer formed on a second electrode 20 is immersed in an ammonia aqueous solution. A concentration of the ammonia aqueous solution is preliminarily coordinated by corresponding to a kind of the n-type dopant, a component of the p-type semiconductor layer or the like. After the second electrode 20 and the p-type semiconductor layer are immersed in an ammonia aqueous solution, a solution of cadmium sulfate ($CdSO_4$) is added into the ammonia aqueous solution. The solution of cadmium sulfate is formed by dissolving cadmium sulfate in the ammonia aqueous solution. The ammonia aqueous solution with cadmium sulfate is retained nearly at 80°C, favorably not less than 80°C, with stirring between several minutes and several tens of minutes. After dissolving cadmium sulfate, the second electrode 20 and the p-type semiconductor layer are transferred from the ammonia aqueous solution to be cleaned by water and be dried. In such a manner, a region at a side of the first electrode 10 in the p-type semiconductor layer is transformed into the n-type to provide the optical absorption layer 30 in which the p-type portion 31 and the n-type portion 32 are jointly formed as a homo junction.

A plurality of semiconductor layers having the same crystalline structure is jointed each other in the homo junction. Furthermore, the semiconductor layers substantially being the same material other than impurities controlling a conductive type are jointed each other.

Mismatch between crystal lattices is not substantially formed at an interface of the junction between the p-type portion 31 and the n-type portion 32 in the optical absorption layer 30 according to the first embodiment. Therefore, a junction without lattice distortion is formed to obtain higher quality in electrical characteristics.

A compound semiconductor with chalcopyrite structure, for example, having a Group 11 element (Group Ib element), at least one Group 13 element (Group III element) selected from Al, In and Ga and at least one Group 16 element (Group VIb element) selected from O, S, Se and Te, is employed as a material of the optical absorption layer 30. The representation of the compound semiconductor is based on IUPAC notation system. The representation in parentheses is the old version of IUPAC notation system.

Cu, for example, is employed as a Group 11 element. Accordingly, the p-type portion 31 of a p-type compound semiconductor can be easily formed. In and Ga, for example, are selected from the Group 13 elements. As a result, a value of a band gap can be easily controlled by a combination of In and Ga to obtain an objective value. The objective value of the band gap is not less than 1.0 eV and not more than 1.7eV. S or Se, for example, is employed as the Group 16 element. In such a manner, characteristics of the junction with the first electrode 10 can be highly improved.

CIGS, for example, is employed as a chalcopyrite compound semiconductor. CIGS is $C_{u\varepsilon}(In_{1-\gamma}Ga_{\gamma})_{\sigma}Se_{\psi}$ ($0.6 \leqq \varepsilon \leqq 1.1$, $0.8 \leqq \sigma \leqq 1.2$, $1.5 \leqq \psi \leqq 2.5$, for example, and has a chalcopyrite structure as a main phase. As CIGS has originally a p-type, a dopant such as Zn, Mg or the like is entered into a Cu defect site when CIGS is transformed into the n-type. S may be alternately employed as a portion of a plurality of Se. In other words, CIGS may be $C_{u\varepsilon}(In_{1-\gamma}Ga_{\gamma})_{\sigma}(Se_{1-\varphi}S_{\varphi})_{\psi}$. In such a case, an arbitrary constant can be used as y and $\varphi$. $CuIn_{1-\gamma}Ga_{\gamma}Se_2$, for example, is employed as CIGS.

More specifically, $Cu(In, Ga)(S, Se)_2$, $Cu(In, Ga)(Se, Te)_2$, $Cu(Al, Ga, In)Se_2$ or $Cu_2ZnSnS_4$ is employed as the optical absorption layer 30. Furthermore, $CuInSe_2$, $CuInTe_2$, $CuGaSe_2$, $CuIn_3Se_5$ or the like is employed as the optical absorption layer 30.

The n-type portion 32 includes an element having a formal charge Vb of not less than 1.96 and not more than 2.65 as a dopant. Mg, Zn, Fe or Co, for example, is nominated as the element of the formal charge Vb in a range not less than 1.60 and not more than 2.83. However, it is not restricted to the elements described above when the formal charge is incorporated in this range. The formal charge is favorably in a range of not less than 1.83 and not more than 2.83, and is further favorably in a range of not less than 1.96 and not more than 2.65.

The formal charge Vb is explained below. A compound semiconductor of the optical absorption layer 30 includes a first element of a Group 11 element and a second element of a Group 16 element in BVS calculation of this embodiment. It is assumed that the first element is substituted by the dopant. The first element is Cu, for example, in this embodiment. Furthermore, the second element is Se, for example. A bond length (angstrom) between the first element and the second element is designated as $r_i$ and a bonding parameter between the dopant and the second element is designated as $r_0$. A proper constant (angstrom) determined by a combination of the dopant and the second element is designated as Bf. A number of neighboring bonds of the second element to the first element is designated as n, where n is an integer not less than one. The compound semiconductor can further include a third element of a Group 13 element.

The bonding parameter $r_0$ is determined in every combination of ion pairs. A combination of four-coordination of a divalent dopant and a minus divalent Se is employed in this embodiment. The proper constant Bf is determined based on structure analysis using a number of inorganic compounds and is 0.37 angstrom in this embodiment. A number of the neighboring bond n is a number of Se around Cu in this embodiment, for example. In this case, the formal charge Vb obtained by BVS calculation is represented by Formula 1 described below.

$$V_b = \sum_{j=1}^{n} \exp\left(\frac{r_0 - r_i}{B_f}\right) \quad \cdots \quad (1)$$

The formal charge Vb belonged to each of ions included in an ion crystal can be divided into each of the bonds coordinated around the ion. The formal charge Vb of an element in a crystal lattice is calculated by BVS calculation. It is considered that the dopant having nearly divalence is easily substituted to the four-coordination sites of Se of a Group 16 element included in the optical absorption layer 30 of a CIGS-compound semiconductor in this embodiment. Furthermore, $r_0$ and Bf are constants and are set on every combination of elements. The values of $r_0$ and Bf are determined based on a large number of data bases having been analyzed in crystallography to be saved. Therefore, values obtained by BVS calculation have a large difference between possible combination of a charge and a bond length, and impossible combination of a charge and a bond length. A data base, for example, is provided in (BVS) Brown and Altermatt, Acta Cryst. B41, 244(1985) or the like. Table 1 is demonstrated the formal charge $Vb$ calculated as an example of the data bases. In Table 1, each unit of $R_i$, $r_0$ and $Bf$ are is described using a unit of angstrom.

[TABLE.1]

|  |  | $r_i$ | $r_0$ | $Bf$ | $n$ | $Vb$ |
|---|---|---|---|---|---|---|
| Mg | $CuIn_1S_2$ | 2.535 | 2.320 | 0.370 | 4 | 2.237 |
|  | $CuIn_{0.7}Ga_{0.3}Se_2$ | 2.509 | 2.320 | 0.370 | 4 | 2.400 |
|  | $CuIn_{0.5}Ga_{0.5}Se_2$ | 2.484 | 2.320 | 0.370 | 4 | 2.568 |
|  | $CuIn_{0.3}Ga_{0.7}Se_2$ | 2.473 | 2.320 | 0.370 | 4 | 2.645 |
|  | $CuGa_1Se_2$ | 2.448 | 2.320 | 0.370 | 4 | 2.830 |
| Zn | $CuIn_1Se_2$ | 2.535 | 2.220 | 0.370 | 4 | 1.707 |
|  | $CuIn_{0.7}Ga_{0.3}Se_2$ | 2.509 | 2.220 | 0.370 | 4 | 1.832 |
|  | $CuIn_{0.5}Ga_{0.5}Se_2$ | 2.484 | 2.220 | 0.370 | 4 | 1.960 |
|  | $CuIn_{0.3}Ga_{0.7}Se_2$ | 2.473 | 2.220 | 0.370 | 4 | 2.019 |
|  | $CuGa_1Se_2$ | 2.448 | 2.220 | 0.370 | 4 | 2.160 |
| Cd | $CuIn_1Se_2$ | 2.535 | 2.400 | 0.370 | 4 | 2.777 |
|  | $CuIn_{0.7}Ga_{0.3}Se_2$ | 2.509 | 2.400 | 0.370 | 4 | 2.979 |
|  | $CuIn_{0.5}Ga_{0.5}Se_2$ | 2.484 | 2.400 | 0.370 | 4 | 3.188 |
|  | $CuIn_{0.3}Ga_{0.7}Se_2$ | 2.473 | 2.400 | 0.370 | 4 | 3.284 |
|  | $CuGa_1Se_2$ | 2.448 | 2.400 | 0.370 | 4 | 3.513 |
| Fe | $CuIn_1Se_2$ | 2.535 | 2.280 | 0.370 | 4 | 2.008 |
|  | $CuIn_{0.7}Ga_{0.3}Se_2$ | 2.509 | 2.280 | 0.370 | 4 | 2.154 |
|  | $CuIn_{0.5}Ga_{0.5}Se_2$ | 2.484 | 2.280 | 0.370 | 4 | 2.305 |
|  | $CuIn_{0.3}Ga_{0.7}Se_2$ | 2.473 | 2.280 | 0.370 | 4 | 2.374 |
|  | $CuGa_1Se_2$ | 2.448 | 2.280 | 0.370 | 4 | 2.540 |
| Co | $CuIn_1Se_2$ | 2.535 | 2.240 | 0.370 | 4 | 1.802 |
|  | $CuIn_{0.7}Ga_{0.3}Se_2$ | 2.509 | 2.240 | 0.370 | 4 | 1.933 |
|  | $CuIn_{0.5}Ga_{0.5}Se_2$ | 2.484 | 2.240 | 0.370 | 4 | 2.069 |
|  | $CuIn_{0.3}Ga_{0.7}Se_2$ | 2.473 | 2.240 | 0.370 | 4 | 2.131 |
|  | $CuGa_1Se_2$ | 2.448 | 2.240 | 0.370 | 4 | 2.280 |

A bond length ri between the first element and the second element is defined by a kind of the first element, a composition ratio of the first element in the compound semiconductor, a kind of the second element, a composition ratio of the second element in the compound semiconductor, a kind of the third element and a composition ratio of the third element in the compound semiconductor.

The third element in the compound semiconductor includes a fourth element (In, for example) and a fifth element (Ga, for example), and a composition ratio of the fourth element in the third element is designated as xx1, and a composition ratio of the fifth element in the third element is designated as xx2. A bond length $r_i$ of $CuIn_{0.7}Ga_{0.3}Se_2$ in Table 1 is 2.509 angstrom and a bond length $r_i$ of $CuIn_{0.5}Ga_{0.5}Se_2$ is 2.484 angstrom. In this case, a bond length $r_i$ of $CuIn_{0.6}Ga_{0.4}Se_2$ is 2.496 angstrom which is interpolated by using the composition ratio xx1 and the composition ratio xx2.

Specifically, a number of coordination of Cu sites in a crystalline structure of $CuIn_{0.5}Ga_{0.5}Se_2$ is four-coordination of Se and bond length $r_i$ of $CuIn_{0.5}Ga_{0.5}Se_2$ is 2.484 angstrom. In a case using Zn as an n-type dopant, $Bf$ and $r_0$ are 0.37 angstrom and 2.22 angstrom, respectively, from the data base of Table.4. In this case, the formal charge $Vb$ can be obtained as 1.96. The value described above is near to divalence of the formal charge Vb of the n-type dopant. In other words, divalent Zn is easily doped in $CuIn_{0.5}Ga_{0.5}Se_2$. Accordingly, homo junction with high quality can be obtained with retaining an excellent crystalline structure when using $CuIn_{0.5}Ga_{0.5}Se_2$ as the optical absorption layer 30 and Zn as the n-type dopant. In such a manner, conversion efficiency of the photoelectric conversion element 100 with high performance can be obtained.

Doping n-type impurities in CIGS is performed by substitution of a divalent dopant with a monovalent Cu-site. Each of many kinds of divalent ions have different ion radius each other and is not clearly existed as a coordination circumstance, four-coordination of Se, in Cu site of the crystalline structure. Consequently, a formal charge V is obtained under assuming that the dopant is substituted with the Cu site of four-coordination of Se using BVS calculation, so that the dopant with near divalence is selected as an effective n-type dopant to screen possible elements.

Table.2 is a result of screening divalent elements by BVS calculation.

[TABLE.2]

|  | SA01 | SA02 | SA03 | SA04 | SA05 |
|---|---|---|---|---|---|
|  | CIS ($\gamma$=0) | CIGS ($\gamma$=0.3) | CIGS ($\gamma$=0.5) | CIGS ($\gamma$=0.7) | CGS ($\gamma$=1) |
|  | 1.0 | 1.1 | 1.3 | 1.4 | 1.7 |
| Mg | 2.24 | 2.40 | 2.57 | 2.65 | 2.83 |
| Zn | 1.71 | 1.83 | 1.96 | 2.02 | 2.16 |
| Cd | 2.78 | 2.98 | 3.19 | 3.28 | 3.51 |
| Fe | 2.01 | 2.15 | 2.30 | 2.37 | 2.54 |
| Co | 1.80 | 1.93 | 2.07 | 2.13 | 2.28 |
| Ni | 1.38 | 1.48 | 1.58 | 1.63 | 1.74 |
| Cu | 1.32 | 1.41 | 1.51 | 1.56 | 1.67 |

In screening, $Cu(In_{1-\gamma}Ga_{\gamma})Se$ is employed as a material of the optical absorption layer 30. A composition ratio Y of In and Ga is changed and each of optical absorption layers 30 has a different kind of the composition. First-fifth absorption layer samples SA01-05 are explained.

The first absorption layer sample SA01 is designated as an optical absorption layer 30 having a composition ratio $\gamma$ of 0.0 and a band gap of 1.0eV. Here, a band gap is a difference between CBM (Conduction Band Minimum) level of a lower end of a conduction band in a p-type portion 31 and VBM (Valence Band Maximum) level of an upper end of a valence band of a p-type portion 31. The second absorption layer sample SA02 is designated as an optical absorption layer 30 having a composition ratio $\gamma$ of 0.3 and a band gap of 1.1eV. The third absorption layer sample SA03 is designated as an optical absorption layer 30 having a composition ratio $\gamma$ of 0.5 and a band gap of 1.3eV. The fourth absorption layer sample SA04 is designated as an optical absorption layer 30 having a composition ratio $\gamma$ of 0.7 and a band gap of 1.4eV. The fifth absorption layer sample SA05 is designated as an optical absorption layer 30 having a composition ratio $\gamma$ of 1.0 and a band gap of 1.7eV.

Mg, Zn and Cd in Group 2 elements or Group 12 elements and Fe, Co, Ni and Cu in other Group elements are employed as the dopant. The formal charge Vb is obtained with respect to each of combination between each of the first-fifth absorption layer samples SA01-05 and each of dopants by BVS calculation.

When the formal charge Vb of Cu substituted by the dopant is calculated by BVS calculation, the values are set to be in a range from 0.72(CIS) to 0.91(CGS) and are smaller than an ideal case of formal charge 1. These results represent that a bond length in the Cu site of Se four-coordination site in CIGS crystal is comparatively longer than a Cu-Se bond in other material so as to be estimated the formal charge Vb to be lower than real monovalent material. In such a case, an n-type dopant having slightly larger number of a formal charge is indicated that a bond length to Se is shorter. In other words, the dopant substituted in the Cu site of Se four-coordination migrates in the crystal to be easily diffused in a film thickness direction. Accordingly, the formal charge Vb calculated by BVS calculation in order to select the n-type dopant is considered to have a suitable value in slightly larger than an ideal divalent value.

Here, a conversion efficiency Eff of a solar cell is described as Formula 2 below using an open voltage Voc, a short-circuit electric current Jsc, a fill factor FF, and an inlet power density P.

$$Eff = Voc \cdot Jsc \cdot FF/P \cdot 100 \quad \cdot \cdot \cdot (2)$$

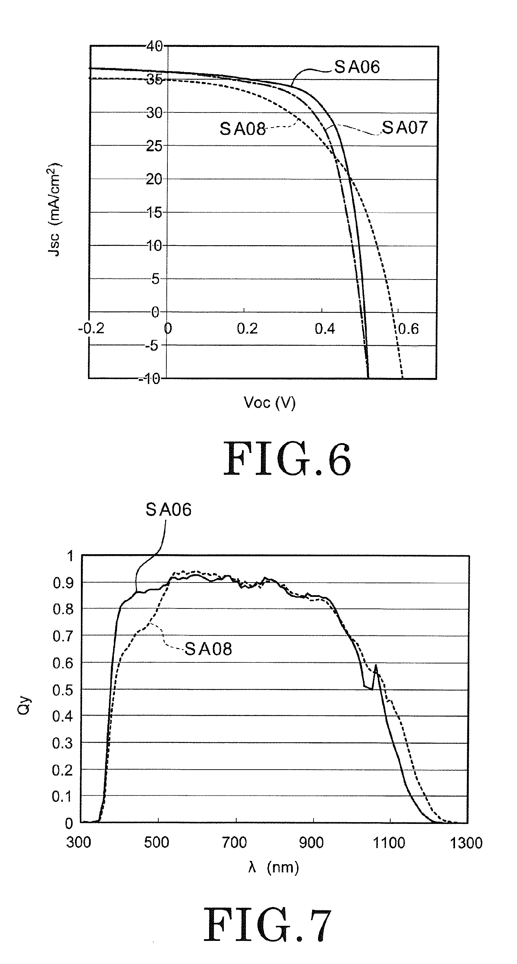

As described in Formula 2, the conversion efficiency is increased with increasing the open voltage Voc, the short-circuit electric current Jsc and the fill factor FF. Theoretically speaking, a larger band gap enlarges the open voltage Voc, however, make smaller the short-circuit current Jsc as shown in Fig.6. Therefore, the maximum of the band gap is designated as nearly 1.4eV, for example.

In this embodiment, the third absorption layer sample SA03 having the band gap of 1.3eV and the fourth absorption layer sample SA04 having the band gap of 1.4eV are mainly employed to explain of a suitable formal charge Vb.

As shown in Fig.2, in the third absorption layer sample SA03 and the fourth absorption layer sample SA04, a case of the third absorption layer sample SA03 with the dopant of Zn has the value of 1.96 which is the nearest formal charge Vb of 2. In the third absorption layer sample SA03 and the fourth absorption layer sample SA04, a case of the fourth absorption layer sample SA04 with the dopant of Mg has the largest formal charge Vb of 2.65 being not less than 3. Accordingly, a suitable formal charge Vb is not less than 1.96 and not more than 2.65 in this embodiment.

Furthermore, an amount of the dopants in the optical absorption layer 30 is favorable not more than $1 \times 10^{16}$ / cm$^3$ in this embodiment. In a dopant distribution of the optical absorption layer 30, it is favorable that an amount of dopants at a side of the first electrode 10 is larger than an average in the optical absorption layer 30.

(Second Embodiment)

Fig.2 is a schematic cross-sectional diagram showing a constitution of a photoelectric conversion element according to a second embodiment. As shown in Fig.2, a photoelectric conversion element 110 according to the second embodiment further includes an intermediate layer 40 between a first electrode 10 and an n-type portion 32. As both the first electrode 10 and a second electrode 20 have the same function and constitution as those of the first embodiment, explanation is omitted.

The intermediate layer 40 has higher resistance than the first electrode 10. Further, the intermediate layer 40 has optical transparency. As the intermediate layer 40, ZnO or the like is employed. The intermediate layer 40 provide band-offset between the first electrode 10 and the n-type portion 32. In such a manner, intermediate layer 40 prevents electrons reached at the first electrode 10 from returning in the n-type portion 32. Accordingly, leakage current can be decreased.

Cu$_2$Se or the like, for example, as lower crystalline quality, may be included in the optical absorption layer 30. The different phase produces an impurity which causes leakage current. The conversion efficiency of the photoelectric conversion element may be decreased due to leakage current. The intermediate layer 40 can decrease leakage current to retain high conversion efficiency. On the other hand, the intermediate layer 40 is not necessary to be set, but can be suitably set when leakage current is large.

(Third Embodiment)

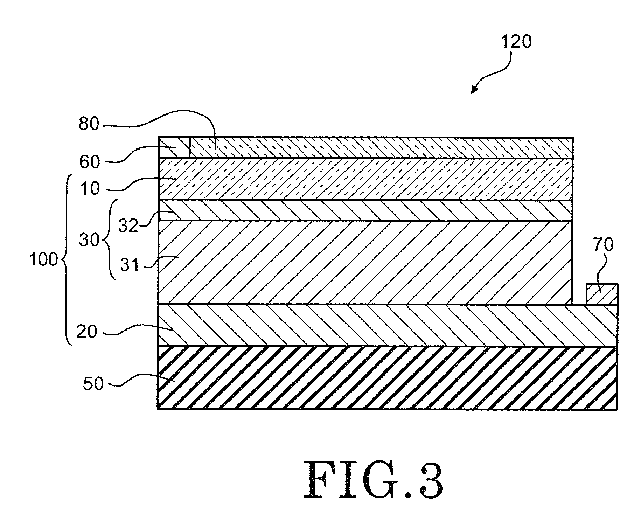

Fig.3 is a schematic cross-sectional view showing a solar cell according to a third embodiment. As shown in Fig.3, a solar cell 120 according to the third embodiment includes an arbitral photoelectric conversion element according to embodiments, a substrate 50 on which the photoelectric conversion element is stacked, a first terminal 60 electrically connected to a first electrode 10, and a second terminal 70 electrically connected to a second electrode 20. In this embodiment, a photoelectric conversion element 100 according to the first embodiment is employed as the photoelectric conversion element according to the arbitral embodiment. On the other hand, a photoelectric conversion element 110 according to the second embodiment can be employed in the solar cell 120. A case employing the photoelectric conversion element 100 is described below.

The substrate 50 is a supporting body supporting the photoelectric conversion element 100. The photoelectric conversion element 100 is provided on the substrate 50. The first terminal 60 is one of an anode and a cathode in the solar cell 120. The second terminal 70 is the other of the anode and the cathode in the solar cell 120. The first terminal 60 is a terminal at an n-type side and the second terminal is a terminal at a p-type side. The photoelectric conversion element 100 is supported by the substrate 50 in the solar cell 120 and electromotive force generated by the photoelectric conversion element 100 is derived via the first terminal 60 and the second terminal 70 to an outer portion.

An anti-reflecting film 80 is provided on the first electrode 10, for example. An area other than the first terminal 60 in a surface of the first electrode 10, on which light is entered, is covered with the anti-reflecting film 80, for example. The anti-reflecting film 80 controls reflection of light entered into the first electrode 10 to increase an amount of light which is absorbed by the optical absorption layer 30.

A method for fabricating the solar cell 120 according to the third embodiment is described below. The example described below is also an example of a method for fabricating the photoelectric conversion element according to the first embodiment or the second embodiment.

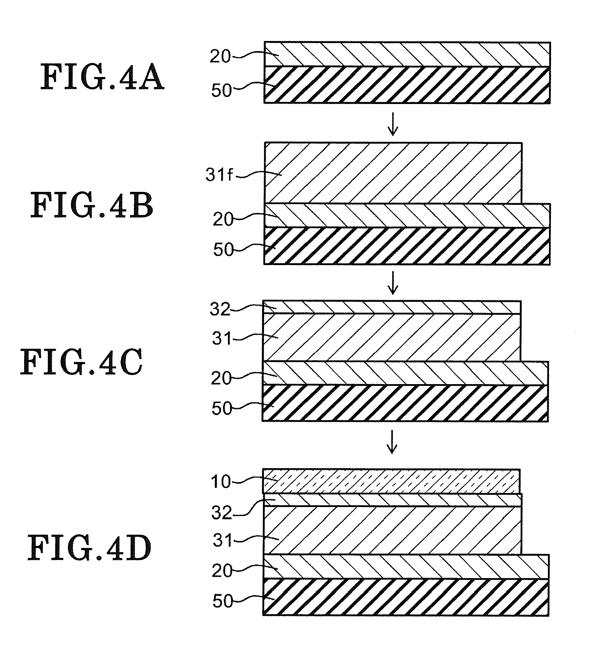

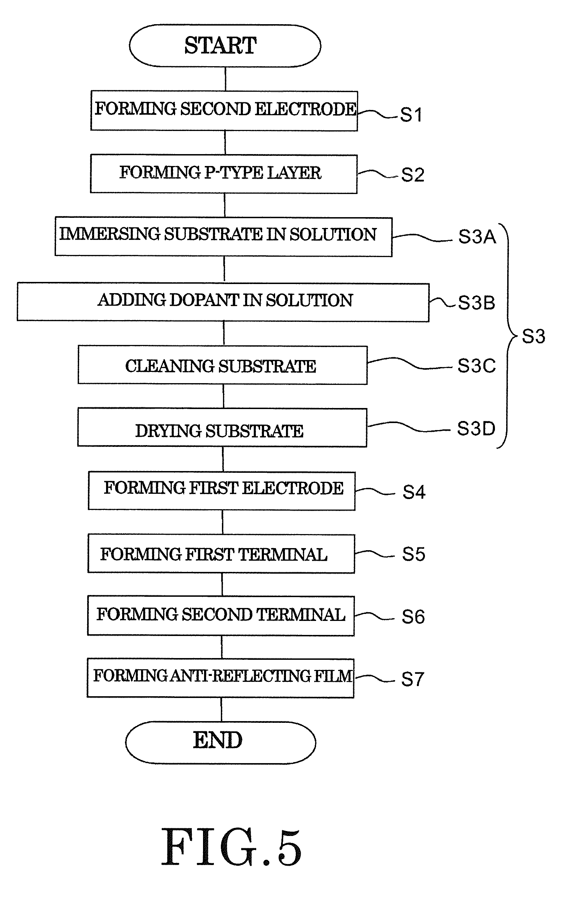

Figs.4A-4D are schematic cross-sectional views showing the method for fabricating the solar cell according to the third embodiment. Further, Fig.5 is a flow chart showing processing steps (steps S1-S7) in a method for fabricating the solar cell according to the third embodiment.

As shown in Fig.4A, the second electrode 20 is provided on the substrate 50 (Step S1 in Fig.5). A soda-lime glass is employed as the substrate 50. The second electrode 20 is a metal layer using a conductive material, Mo or the like, for example. The second electrode 20 is provided by using a thin film growth, sputtering using a target composed of a metal Mo, plating or the like, for example. When using sputtering, a substrate temperature is set to be not less than 10°C and not more than 400°C in an atmosphere with Ar. In a sputtering process, a pressure is changed to suitably control adhesion between the second electrode 20 and the substrate 50 and resistivity of the second electrode 20.

As shown in Fig.4B, a p-type layer 31f is provided on the second electrode 20 to form the p-type portion 31 (Step S2). The p-type layer 31f is formed by thin film growth, such as evaporation, sputtering, forming Se compound, CVD, slurry method, plating or the like. A three-step method is employed in evaporation. In the three-step method, a high quality film can be obtained by controlling an amount of Cu, In, Ge or Se, for example.

An optical absorption layer 30 is provided on the second electrode 20 (Step S3). As shown in Fig.3C, a surface of the p-type layer 31f is transformed into an n-type to form of the p-type portion 31 and the n-type portion 32 (Step S3A-S3D) in forming the optical absorption layer 30. In such a manner, the optical absorption layer 30 is provided. After transforming the surface region of the p-type layer 31f into the n-type, the intermediate layer 40 is provided on the n-type portion 32 in a case of the optical absorption layer 30 including the intermediate layer 40 as reference to Fig.2.

Immersion is employed to provide the p-type portion 31 and the n-type portion 32. The substrate 50 after forming the p-type layer 31f is immersed in an ammonia aqueous solution in immersion (Step S3A). After that, a dopant is added in the ammonia aqueous solution (Step S3B). In a case that Cd is employed as the dopant, for example, $CdSO_4$ is dissolved into the ammonia aqueous solution, subsequently, the ammonia aqueous solution with $CdSO_4$ is added into the ammonia aqueous solution including the substrate 50. After adding the dopant, the substrate 50 is retained in the ammonia aqueous solution with being stilled or stirred between a several minutes and a several tens of minutes. In the step, the ammonia aqueous solution can be heated. When the temperature of the ammonia aqueous is too high, the ammonia aqueous solution is boiled so that formation of the n-type portion 32 is difficult. Therefore, the temperature of the ammonia aqueous solution is designated as not less than 0°C and not more than 100°C. A suitable temperature is nearly 80°C, for example, not less than 70°C and not more than 90°C, favorably over 80°C.

The substrate 50 is immersed in the ammonia aqueous solution with the dopant between a several minutes and a several tens of minutes. After that, the substrate 50 is transferred from the ammonia aqueous solution to be cleaned using water (Step S3C). After cleaning the substrate 50, the substrate 50 is blown by dry air or the like (Step S3D). In such a manner, the surface of the p-type layer 31f is transformed into the n-type, as a result, the p-type portion 31 and the n-type portion 32 are provided by immersion, and finally, the optical absorption layer 30 is completed.

As shown in Fig.4D, a first electrode 10 is provided on the optical absorption layer 30 (Step S4). In forming the first electrode 10, thin film growth, sputtering, CVD or the like, for example, is employed.

After providing the first electrode 10, a first terminal 60 is provided on the first electrode 10 (Step S5). The second terminal 70 is provided on the second electrode 20 (Step S6). An anti-reflecting film 80 is provided on the first electrode 10 to cover a portion other than the first terminal 60 (Step S7). The solar cell 120 is completed through the processing steps mentioned above.

In such a manner, the method for fabricating the photoelectric conversion element and the solar cell includes at least providing the second electrode 20 on the substrate 50 (Step S1), providing the p-type layer 31f on the second electrode 20 (Step S2), transforming the surface of the p-type layer 31f into the n-type to provide the optical absorption layer 30 (Step S3), providing the first electrode 10 on the optical absorption layer 30 (Step S4). Furthermore, providing the optical absorption layer 30 includes contacting the substrate 50 having the p-type layer 31f to a solution with the dopant. At least immersing the substrate 50 formed with the p-type layer 31f in the ammonia aqueous solution (Step S3A) and adding the dopant into the ammonia aqueous solution (Step S3B) are included in providing the optical absorption layer 30, for example.

As described above, the ammonia aqueous solution is employed as a solvent of the dopant in immersion. $Cu_2Se$, for example, can be removed by using the ammonia aqueous solution as the solvent. Further, an oxide layer at a surface can be removed and unnecessary Na can be removed.

$Cu_2Se$ is composed of a semi-metal layer with lower resistivity and has harmful influences on performance of the solar cell. The ammonia aqueous solution removes or modifies $Cu_2Se$ on the surface of the n-type portion 32. In such a manner, the surface of the n-type portion 32 is changed to have high resistivity, so that performance of the solar cell can be improved.

An oxide film or a metal-oxygen compound, for example, is formed on the surface of the p-type layer 31f. The oxide film is formed when the surface of the p-type layer 31f is exposed in air, for example, accompanying with transferring the sample between apparatuses. The ammonia aqueous solution can remove the oxide film. Bubbles can be specifically observed in the immersion process, the ammonia aqueous solution clearly removes the oxide film from the surface of the p-type layer 31f. Removing the oxide film leads to improve the surface of the n-type portion 32, so that performance of the solar cell can be improved.

The ammonia aqueous solution acts as alkali etching agent as the same as KCN or the like. Therefore, the ammonia aqueous solution can dissolve Na ion or the like attached on the surface of the p-type layer 31f to be removed, so that decreasing of performance of the solar cell by non-uniform diffusion can be suppressed.

In such a manner, as the ammonia aqueous solution is employed as the solvent of the n-type dopant in the immersion process, a different phase such as $Cu_2Se$ or the oxide layer formed on the surface of the p-type layer 31f can be removed to improve the film quality of the n-type portion 32, so that performance of the solar cell can be raised.

In evaporation or the like which is a doping method with high energy, not only a Cu defect site or a Cu site but also an In site or a Ga site are substituted by the dopant. The In site and the Ga site act as an acceptor to obstruct transformation of the p-type layer 31f into the n-type. On the other hand, substitution of the In site or the Ga site is prevented and the Cu defect site or the Cu site is selectively substituted in immersion process.

As the films stacked by high energy in evaporation or the like, the surface of the p-type layer 31f is damaged to decrease film quality.

A dopant concentration included in the n-type portion 32 is highly up to 1-20%. When the dopant concentration is high, reaction of substitution between trivalent In site or Ga site and divalent dopant is preceded. In this case, the substituted site is act as an acceptor, transformation of the p-type layer 31f into the n-type is prevented. When the dopant concentration is high, chalcopyrite crystalline structure of the p-type layer 31f is transformed. When the crystalline structure is transformed, a band gap or electrical characteristics also changed to decrease performance of the solar cell.

On the other hand, in the immersion process, the dopant concentration can be suppressed. The dopant with a concentration of 0.1% is doped by using immersion, for example. In such a way, substitution of the In site or the Ga site is suppressed and the crystalline structure of the p-type layer 31f can be retained to suppress decrease of performance of the solar cell.

The dopant concentration can be measured by SIMS (Secondary electron Ion Mass Spectroscopy). A standard sample is employed in quantitative measurement by SIMS. When a beam is entered at a side of the first electrode 10, a tail of the concentration distribution of Zn or Mg used in the first electrode 10 is overlapped with a position of the dopant. When a beam is entered at a side of the substrate 50, the concentration distribution or diffusion distance of Zn or Mg included in the n-type portion 32 can be suitably measured.

Characteristics of the solar cell and the photoelectric conversion element according to the third embodiment are explained as examples. A soda-lime glass having a length of 2.5mm, a width of 12.5mm and a thickness 1.8mm is employed as the substrate 50 in samples. A second electrode 20 composed of simple Mo as a film is provided on the substrate 50. The second electrode 20 is formed by sputtering in argon atmosphere, for example. The second electrode 20 has a thickness of not less than 500nm and not more than $1\mu m$. The p-type layer 31f is provided on the second electrode 20. The p-type layer 31f is formed by evaporation, for example. The p-type layer 31f has a thickness of nearly $2\mu m$, for example, not less than $1\mu m$ and not more than $3\mu m$.

The sample is doped with the n-type dopant by immersion. The substrate 50 with the p-type layer 31f is immersed in the ammonia aqueous solution preliminarily coordinated. $ZnSO_4$, for example, is dissolved in the ammonia aqueous solution, and the ammonia aqueous solution with $ZnSO_4$ is added into the ammonia in which the substrate 50 is immersed. The ammonia aqueous solution is retained at a temperature of 80°C with stirring. The substrate 50 is transferred from the ammonia aqueous solution to be cleaned by water and be dried. In such a manner, Zn is doped in the surface of the p-type layer 31f to provide the p-type portion 31 and the n-type portion 32 jointly having the homo junction. In such a manner, the optical absorption layer 30 is provided.

The first electrode 10 is provided on the optical absorption layer 30. ZnO:Al or ZnO:B is employed as the first electrode 10. The first electrode 10 is formed by sputtering, for example. The first electrode 10 has a thickness of nearly 200nm, for example, not less than 100nm and not more than 300nm. After that, the first terminal 60, the second terminal 70 and the anti-reflecting film 80 are provided. Al is employed as the first terminal 60 and the second terminal 70, for example.

$ZnSO_4$ is employed as a material of the dopant in the sixth absorption layer sample SA06. In other words, the dopant of the sixth absorption layer sample SA06 is Zn.

On the other hand, Mg is employed as the dopant of the n-type portion 32 in the seventh absorption layer sample SA07. A constitution of the seventh absorption layer sample SA07 is the same as that of the sixth absorption layer sample SA06 other than the kind of the dopant. In a case of employing Mg as the dopant, $MgI_2$, for example, is dissolved in the ammonia aqueous solution, and the ammonia aqueous solution with $MgI_2$ is added into the ammonia aqueous solution in which the solution substrate 50 is immersed. The ammonia aqueous solution is retained at a temperature of 80°C, for example, not less than 70°C and not more than 90°C with stirring. The substrate 50 is transferred from the ammonia aqueous solution to be cleaned by water and be dried. In such a manner, n-type portion 32 doped with Mg is provided.

On the other hand, an n-type semiconductor composed of CdS is provided on the p-type layer 31f in the eighth absorption layer sample SA08. In such a manner, the p-type layer 31f and the n-type semiconductor have jointly the hetero junction in the eighth absorption layer sample. Each of the sixth absorption layer sample SA06 and the seventh absorption layer sample SA07 has a constitution according to the fourth embodiment, however, the eighth absorption layer sample SA08 is corresponded to a reference example.

Fig.6 is a graph showing voltage-current characteristics according to the sixth-eighth absorption layer samples. A horizontal axis in Fig.6 is an open voltage in the sixth-eighth absorption layer samples SA06-08. A vertical axis in Fig.6 is a short-circuit current Jsc in the sixth-eighth absorption layer samples SA06-08. A conversion efficiency Eff of the sixth absorption layer sample SA06 using Zn as the dopant is 12.4%. A conversion efficiency Eff of the seventh absorption layer sample SA07 using Mg as the dopant is 11.3%. A conversion efficiency Eff of the eighth absorption layer sample SA08 having the p-type layer 31f and the n-type semiconductor in which the hetero junction is jointly formed is 10.3%. As specifically described above, the conversion efficiencies in the photoelectric conversion element and the solar cell 120 including the photoelectric conversion element according to the third embodiment are improved.

Fig.7 is a graph showing characteristics of quantum efficiency of the sixth absorption layer sample and the eighth absorption layer sample. A horizontal axis in Fig.7 is wave length $\lambda$. A vertical axis in Fig.7 is quantum efficiency Qy of the sixth absorption layer sample SA06 and the eighth absorption layer sample SA08. The quantum efficiency Qy represents a probability of reaction of a molecular when one molecular absorbs one photon. Accordingly, when the quantum efficiency Qy is larger, the sample highly absorbs light.

The quantum efficiency Qy of the sixth absorption layer sample SA06 at the wave length of 450nm is 0.89. The quantum efficiency Qy of the eighth absorption layer sample SA08 at the wave length of 450nm is 0.72. As described above, photo absorbability near the wave length of 400-500nm is improved in the sixth absorption layer sample SA06 as compared to the eighth absorption layer sample SA08.

In other words, a loss of photo absorption near 2.7eV included in photo absorption of the p-type portion 31 is smaller in the sixth absorption layer sample SA06 as compared to the eighth absorption layer sample SA08. Improvement of the conversion efficiency in the photoelectric conversion element and the solar cell 120 including the photoelectric conversion element according to the third embodiment is originated in the improvement of the loss of photo absorption.

As described above, the conversion efficiency in the photoelectric conversion element and the solar cell 120 including the photoelectric conversion element according to the third embodiment is improved by suitably setting the dopant of the n-type portion 32 of the CIGS system.

(Fourth Embodiment)

Next, a fourth embodiment is described below. In this embodiment, a first compound of a metal compound having optical transparency and conductive, including at least one of $(Zn_{1-x}Mg_x)_{1-y}M_yO$ and $Zn_{1-ß}M_ßO_{1-\alpha}S_\alpha$, is employed as the first electrode 10 described in the first embodiment, where M is one element selected from a group of B, Al, Ga and In. Furthermore, each constant of x, y, $\alpha$ and ß has relations of $0.03 \leqq x \leqq 0.4$, $0.005 \leqq y \leqq 0.2$, $0.4 \leqq \alpha \leqq 0.9$ and $0.005 \leqq ß \leqq 0.2$, respectively. As both the first electrode 10 and the second electrode 20 have the same function and constitution as those of the first embodiment, explanation is omitted.

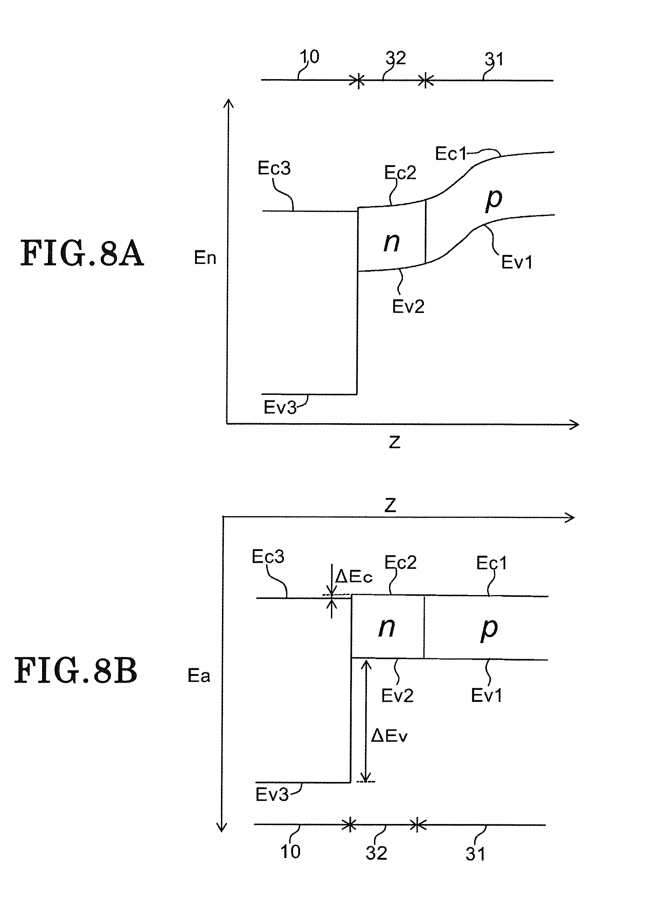

Figs.8A, 8B are schematic band diagrams showing a constitution of the photoelectric conversion element according to the fourth embodiment. Fig.8A is a band diagram showing a potential energy En based on Fermi level. In Fig.8A, the horizontal axis and the vertical axis are a thickness direction (Z-direction) from the first electrode 10 to the second electrode 20 and a potential energy En, respectively. The potential energy En is set by using electron energy as a standard. In Fig.8A, the upper direction of the vertical axis is corresponded to a direction of increasing the electron energy. Fig.8B is a band diagram showing an electron affinity Ea by using vacuum level as a standard. In Fig.8B, the horizontal axis and the vertical axis are the thickness direction (Z-direction) from the first electrode 10 to the second electrode 20 and the electron affinity Ea, respectively. In Fig.8B, the lower direction of the vertical axis is corresponded to a direction of increasing the electron affinity Ea apart from vacuum level.

As shown in Figs. 8A, 8B, a band gap is difference between an energy level Ec1 of CBM (Conduction Band Minimum) located at the lower end of conduction band in the p-type portion 31 and an energy level Ev1 of VBM (Valence Band Maximum) located at the upper end of valence band in the p-type portion 31. The band gap in the optical absorption layer 30 is set to be not less than 1.0 eV and not more than 1.7 eV in the first embodiment.

In the photoelectric conversion element 100, the p-type portion 31 and the n-type portion 32 jointly have a homo junction. Therefore, as shown in Fig.8A, the energy level Ec1 of CBM in the p-type portion 31 is continuously connected to an energy level Ec2 of CBM in the n-type portion 32. In other words, a band off-set is substantially not generated between the energy levels Ec1 and Ec2. As the same above, the energy level Ev1 of VBM in the p-type portion 31 is continuously connected to an energy level Ev2 of VBM in the n-type portion 32. A band off-set is substantially not generated between the energy levels Ev1 and Ev2, too.

In the photoelectric conversion element 100, a first compound including at least one of (Zn, Mg) O:M and Zn (O, S):M, is employed as the first electrode 10, and a compound semiconductor having chalcopyrite structure is employed as the optical absorption layer 30, so that the energy level of Ec2 of CBM in the n-type portion 32 and an energy level Ec3 of CBM in the first electrode 10 are coordinated. In such a manner, as shown in Fig.2A, the energy levels Ec1 and Ec2 are continuously decreased along the direction directed from the p-type portion 31 to the first electrode 10.

As shown in Fig.8B, in the photoelectric conversion element 100, the coordinating the energy levels Ec2 an Ec3 enables to set the absolute value of a band offset ΔEc of the electron affinity Ea generated between the n-type portion 32 and the first electrode 10 to be not more than 0.1eV. The band offset Δ Ec is an energy difference between the energy levels Ec2 and Ec3. Namely, the value of the band offset ΔEc is set in a range ± 0.1eV, so that current of electrons from the optical absorption layer 30 to the first electrode 10 can be smoothly controlled to suppress generation of recombination.

Further, the energy level Ec1 of the p-type portion 31 is substantially the same as the energy level Ec2 of the n-type portion 32. Accordingly, ΔEc is corresponded to an energy difference between the energy levels Ec1 and Ec3. In other words, the band offset Δ Ec is an energy difference between CBM of the optical absorption layer 30 and CBM of the first electrode 10.

In the photoelectric conversion element 100, Ev1 and Ev2 are continuously decreased along a direction from the p-type portion 31 to the first electrode 10 as the same as the energy levels Ec1 and Ec2. Further, in the photoelectric conversion element 100, a band offset ΔEv between VBM of the first electrode 10 and VBM of the optical absorption layer 30 is sufficiently generated. The band offset ΔEv is an energy difference between the energy levels Ev2 and Ev3.

In such a manner, current of holes from the first electrode 10 to the optical absorption layer 30 can be smoothly controlled to suppress generation of recombination.

In such a manner, in the photoelectric conversion element 100, the p-type portion 31 and the n-type portion 32 jointly have a homo junction, so that interface states between the p-type portion 31 and the n-type portion 32 are hard to be generated. Further, the first compound and the compound semiconductor having a chalcopyrite structure are employed as the first electrode 10 and the optical absorption layer 30, respectively, to coordinate the energy levels Ec2, Ec3, Ev2 and Ev3, so that recombination between electrons and holes can be suppressed. The photoelectric conversion element 100 can suppress decrease of conversion efficiency due to interface states and recombination between electrons and holes.

A constitution employing ZnO:Al or ZnO:B as a material of the first electrode 10 of the photoelectric conversion element 100 with CIGS-system can be also proposed. However, CBM of the optical absorption layer 30 is increased with increasing a composition ratio of Ga in the optical absorption layer 30 to overmuch enlarge difference between CBM of the optical absorption layer 30 and CBM of the first electrode 10 when employing ZnO:Al or ZnO:B. Therefore, conversion efficiency is lower in the above constitution.

In contrast to the above case, $(Zn_{1-x}Mg_x)_{1-y}Al_yO$ is employed as the first electrode 10, for example, according to the first embodiment. Further, a composition ratio of Mg is coordinated that CBM of the first electrode 10 is adjusted to CBM of the optical absorption layer 30. As a result, a part of Zn atoms is substituted with Mg atoms. Furthermore, a composition ratio of Al is adjusted in a case of using $(Zn_{1-x}Mg_x)_{1-y}Al_yO$. A composition ratio y of Al is corresponded to a carrier concentration. In such a manner, in a case of $(Zn_{1-x}Mg_x)_{1-y}Al_yO$, the first electrode 10 adjusting to each of the p-type portion 31 and the n-type portion 32 can be fabricated.

A composition ratio of Mg, for example, is set to be not less than 0.0 and not more than 0.4. An optimum composition ratio X of Mg is changed by a composition of the optical absorption layer 30. The optimum composition ratio X of Mg is not less than 0.0 and not more than 0.3, for example, when a composition ratio of Ga is nearly 0.3. Further, higher efficiency can be obtained in CuInGaSe solar cell when the composition ratio of Ga is set to be 0.3. In addition, a value of CBM or Fermi level can be measured by UPS (Ultra-violet Photoemission Spectroscopy), XPS (X-ray Photoemission Spectroscopy) or the like.

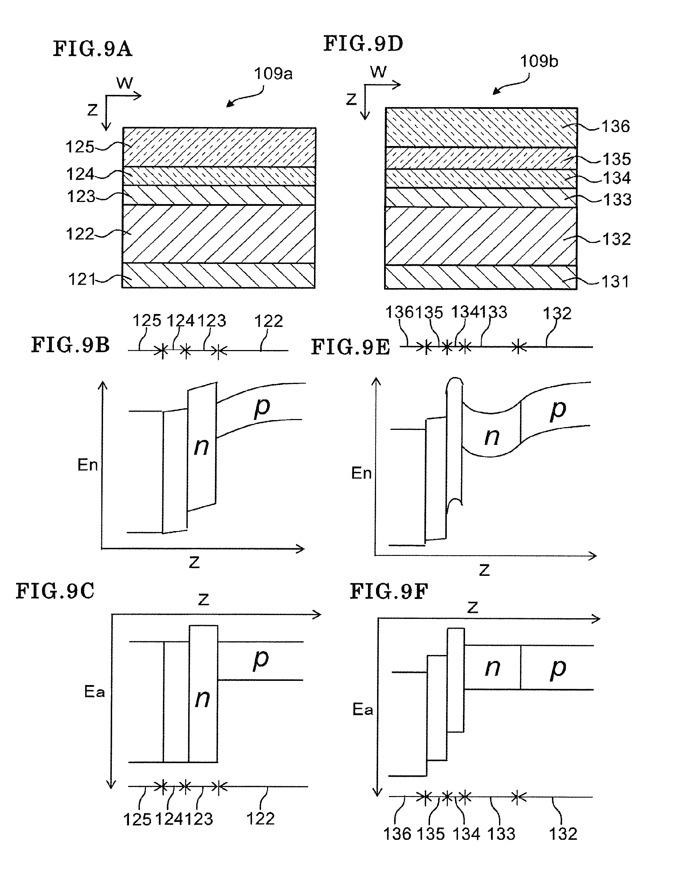

Figs.9A-9F are schematic diagrams showing a constitution of photoelectric conversion elements of a first reference example and a second reference example. Fig.9A is a schematic cross-sectional view showing a band diagram of potential energy of the first reference example. Fig.9B is a schematic band diagram showing potential energy of the first reference example. Fig.9C is a schematic band diagram showing an electron affinity of the first reference example. As shown in Fig.9A, the photoelectric conversion according to the first reference example includes a lower electrode 121 composed of Mo, a p-type optical absorption layer 122 composed of CIGS compound semiconductor, an n-type buffer layer 123 composed of CdS, a window layer 124 being a high resistance semiconductor composed of ZnMgO and a transparent electrode 125 composed of ZnMgO:Al.

In a photoelectric conversion element 109a, the n-type buffer layer 123 is provided on the optical absorption layer 122 to generate a p-n hetero junction. When lower resistance impurities are generated in the optical absorption layer 122 during a film growth process, leakage current is generated in the photoelectric conversion element 109a to lower conversion efficiency. The buffer layer 123 is introduced to reduce the leakage current due to the impurities for suppressing the conversion efficiency to be lower.

In the photoelectric conversion element 109a, selection of materials of the optical absorption layer 122, the buffer layer 123 and the window layer 124 is determined so that electron affinities of the buffer layer 123 and the window layer 124 are set to be not more than an electron affinity of the optical absorption layer 122, and selection of material of the transparent electrode 125 is determined so that an electronic affinity of the transparent electrode 125 is set to be not more than the electronic affinity of the window layer 124.

In the photoelectric conversion element 109a, as the optical absorption layer 122 and the buffer layer 123 are provided as a p-n hetero junction, control of a relation between CBM of the optical absorption layer 122 and CBM of the buffer layer 123 is necessary. In such a case, a band off-set of nearly 0.3 eV between the optical absorption layer 122 and the buffer layer 123 is created. Furthermore, in the photoelectric conversion element 109a, conversion efficiency is decreased by generation of interface states due to the hetero junction.

Fig.9D is a schematic cross-sectional view showing a constitution of the second reference example. Fig.9E is a band diagram schematically showing a potential energy of the second reference example. Fig.9F is a band diagram schematically showing an electron affinity of the second reference example. The photoelectric conversion element 109b according to the second reference example includes a lower electrode 131 composed of Mo, a p-type CIGS layer 132, an n-type CIGS layer 133, an n-type buffer layer 134 composed of $Zn(O, S)$, an n-type window layer 135 composed of ZnO and a transparent electrode 136 composed of an ITO film.

After providing the n-type buffer layer 134 on the p-type CIGS layer 132, Zn included in the n-type buffer layer 134 is diffused into a crystal of the p-type CIGS layer 132 to provide the n-type CIGS layer 133. In such a way, the p-type CIGS layer 132 and the n-type CIGS layer 133 are connected via a p-n homo junction.

In a photoelectric conversion element 109b according to the second reference example, the p-type CIGS layer 132 and the n-type CIGS layer 133 jointly have a p-n homo junction, so that mismatch of crystalline lattice is suppressed. Accordingly, interface states are hard to be generated. However, the photoelectric conversion element 109b includes a band offset between the n-type CIGS layer 133 and the transparent electrode 136 to cause decrease of conversion efficiency depending on recombination between electrons and holes.

The n-type buffer layer 134 with high resistance is provided between the n-type CIGS layer 133 and the transparent electrode 136. Consequently, CBM of the n-type buffer layer 134 is smaller than CBM of the transparent electrode 136 in the photoelectric conversion element 109b to generate a band offset between the n-type CIGS layer 133 and the transparent electrode 136, as shown in Fig.9F. Furthermore, CBM and VBM of the n-type CIGS layer 133 is once decreased along a direction from the p-type CIGS layer 132 to the n-type buffer layer 134, and is successively increased again in the photoelectric conversion element 109b, as shown in Fig.9E. As a result, electrons and holes are accumulated near an interface between the n-type CIGS layer 133 and the n-type buffer layer 134 so as to be easily recombined in the photoelectric conversion element 109b.

In contrast to the above case, the p-type portion 31 and the n-type portion 32 is connected via the homo junction in the photoelectric conversion element 100 according in this embodiment, so that decrease of conversion efficiency is not caused by generation of recombination between electrons and holes. Further, Ec2, Ec3, Ev2 and Ev3 are coordinated to suppress recombination generation, so that decrease of conversion efficiency is not substantially generated due to recombination between electrons and holes.

(Fifth Embodiment)

In a case of the photoelectric conversion element 110 in the second embodiment having the intermediate layer 40, the first compound having at least one of $(Zn_{1-x}Mg_x)_{1-y}M_yO$ and $Zn_{1-ß}Mg_ßO_{1-\alpha}S_\alpha$ is employed as the first electrode 10 and the second compound is employed as the intermediate layer 40. The second compound is a material corresponded to both y and ß being less than 0.005 in the first compound of the first electrode 10. In other words, the second compound includes at least one of $(Zn_{1-x}Mg_x)_{1-y}M_yO$, $Zn_{1-ß}Mg_ßO_{1-\alpha}S_\alpha$, $(Zn, Mg)O$ and $Zn(O, S)$. Impurities may be diffused into the first electrode 10 when the first electrode 10 is formed, as a result, y and ß may have a case with no zero. A concentration of a dopant element, Al, for example, in the intermediate layer 40 is set to be lower than a concentration of a dopant element in the first electrode 10. Both y and ß be desirably zero. The carrier concentration can be measured by ECV (Electrochemical Capacitance-Voltage) or the like. Accordingly, a composition of the intermediate layer 40 can be judged from data of the carrier concentration.

As the second compound is employed as the intermediate layer 40, a band offset is not substantially generated between the intermediate layer 40 and the n-type portion 32, so that the photoelectric conversion element 110 can obtain a superior crystalline quality to retain high conversion efficiency.

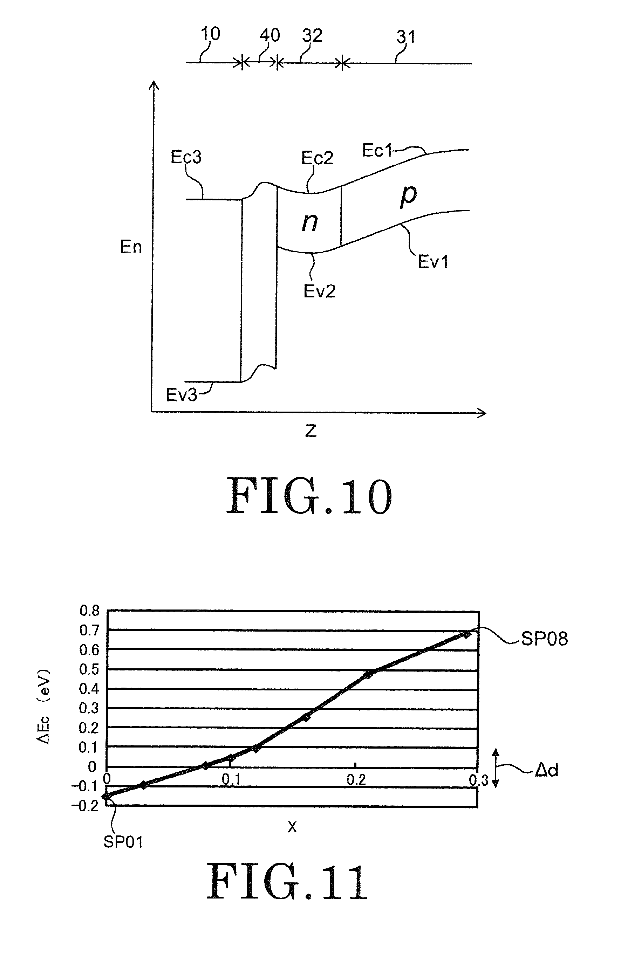

Fig.10 is a schematic band diagram showing a constitution of the photoelectric conversion element as example, according to the fifth embodiment.

As shown in Fig.10, potential energies of conduction band and valence band in the intermediate layer 40 are higher than those of the first electrode 10, respectively. Therefore, a mount of potential energy is generated between the n-type portion 32 and the first electrode 10 in the photoelectric conversion element 110. Further, energy levels Ec2 and Ev2 of the photoelectric conversion element 110 are once decreased along a direction from the p-type portion 31 to the intermediate layer 40 and are successively increased again. In such a manner, the mount of potential energy is provided between the n-type portion 32 and the first electrode 10 in the intermediate layer 40. As described above, electrons once transferred to the first electrode 10 and the intermediate layer 40 are suppressed to reversely turn the n-type portion 32 in the intermediate layer 40. In such a manner, leakage current can be decreased.

Cu₂Se or the like, for example, as lower crystalline quality, may be included in the optical absorption layer 30. The different phase produces an impurity which causes leakage current. The conversion efficiency of the photoelectric conversion element may be decreased due to leakage current. The intermediate layer 40 can decrease leakage current to retain high conversion efficiency. On the other hand, the intermediate layer 40 is not necessary to be set, but can be suitably set when leakage current is large.

Characteristics of the solar cell and the photoelectric conversion element according to the fifth embodiment, for example, are described below when the first compound is used as the first electrode 10. A soda-lime glass having a length of 2.5mm, a width of 12.5mm and a thickness of 1.8mm is employed as the substrate 50 in samples. A second electrode 20 composed of Mo is provided on the substrate 50 by sputtering using a target with simple Mo in Ar atmosphere. A thickness of the second electrode 20 is set to be 500nm.

The p-type layer 31f is provided on the second electrode 20 by using MBE (Molecular Beam Epitaxy). A thickness of the p-type layer 31f is set to be 2$\mu$m. A band gap of the p-type layer 31f is approximately 1.1eV. In other words, a band gap of the p-type portion 31 is approximately 1.1 eV.

Zn is introduced on a surface portion of the p-type layer 31f by immersion to form the n-type portion 32. In such a way, the p-type portion 31 is formed at a lower portion of the p-type layer 31f. The first electrode 10 is formed on the n-type portion 32. The first electrode 10 is formed by sputtering in Ar atmosphere, for example.

A first compound of $(Zn_{1-x}Mg_x)_{1-y}Al_yO$ is employed as the first electrode 10. In such an example, a composition ratio x is changed to obtain first-eighth electrode samples SP01-08. Carrier impurities of the first compound are doped corresponding to the composition ratio x of Mg. A composition ratio y of Al is coordinated between not less than 0.01 and not more than 0.05 to suppress an extreme decrease of mobility.

The solar cell including a photoelectric conversion element 109a with a constitution of the first reference example is called first comparative samples. A constitution including the optical absorption layer 122 is designated as the same as the first-eighth electrode samples SP01-08 other than forming an n-type on a surface portion of the p-type layer 31. CdS is employed as a buffer layer 123. ZnO is employed as a window layer 124. ZnO:Al is employed as a transparent electrode 125.

A solar cell including an intermediate layer 40 is called a second comparative sample. A material of the first electrode 10 without Al is employed as the intermediate layer 40. In other words, (Zn, Mg) is employed as the first electrode 10 in the fifth embodiment. The intermediate layer 40 is formed by sputtering in Ar atmosphere, for example, as the same as the first electrode 10. In the second comparative samples, the first electrode 10 and the intermediate layer 40 are formed in a composition ratio x of Mg as 0.08. Processing steps of the second comparative samples are the same steps as the first-eighth electrode samples SP01-08 other than forming the intermediate layer 40.

Characteristics of the first-eight electrode samples SP01-08 are demonstrated in Table 3. A band offset $\Delta$Ec, an open voltage Voc, an output factor FF and conversion efficiency Eff on each of the first-eighth electrode samples SP01-08 are shown in Table.3.

Furthermore, each of values of the second-eighth electrode samples SP02-08 are normalized by each value of $\Delta$Ec, Voc, FF and Eff of the first electrode sample having the composition ratio x of Mg being zero are also shown in Table.3. Namely, Norm.Voc, Norm.Jsc, Norm.FF and Norm.Eff are values of Voc, Jsc, FF and Eff after the normalization, respectively, in Table.3.

[TABLE.3]

| | X | $\Delta$Ec(eV) | Voc (V) | Jsc (mA/cm²) | FF | Eff. (%) | Norm. Voc | Norm. Jsc | Norm. FF | Norm. Eff. |
|---|---|---|---|---|---|---|---|---|---|---|
| SP01 | 0.00 | -0.15 | 0.60 | 35.0 | 0.70 | 14.70 | 1.00 | 1.00 | 1.00 | 1.00 |
| SP02 | 0.03 | -0.09 | 0.62 | 37.0 | 0.72 | 16.52 | 1.03 | 1.06 | 1.03 | 1.12 |
| SP03 | 0.08 | 0.01 | 0.65 | 36.5 | 0.75 | 17.79 | 1.08 | 1.04 | 1.07 | 1.21 |
| SP04 | 0.10 | 0.05 | 0.65 | 36.4 | 0.74 | 17.51 | 1.08 | 1.04 | 1.06 | 1.19 |
| SP05 | 0.12 | 0.10 | 0.66 | 35.8 | 0.71 | 16.78 | 1.10 | 1.02 | 1.01 | 1.14 |
| SP06 | 0.16 | 0.26 | 0.63 | 33.1 | 0.67 | 13.97 | 1.05 | 0.95 | 0.96 | 0.95 |
| SP07 | 0.21 | 0.48 | 0.58 | 31.1 | 0.62 | 11.18 | 0.97 | 0.89 | 0.89 | 0.76 |
| SP08 | 0.29 | 0.69 | 0.55 | 28.9 | 0.50 | 7.95 | 0.92 | 0.83 | 0.71 | 0.54 |

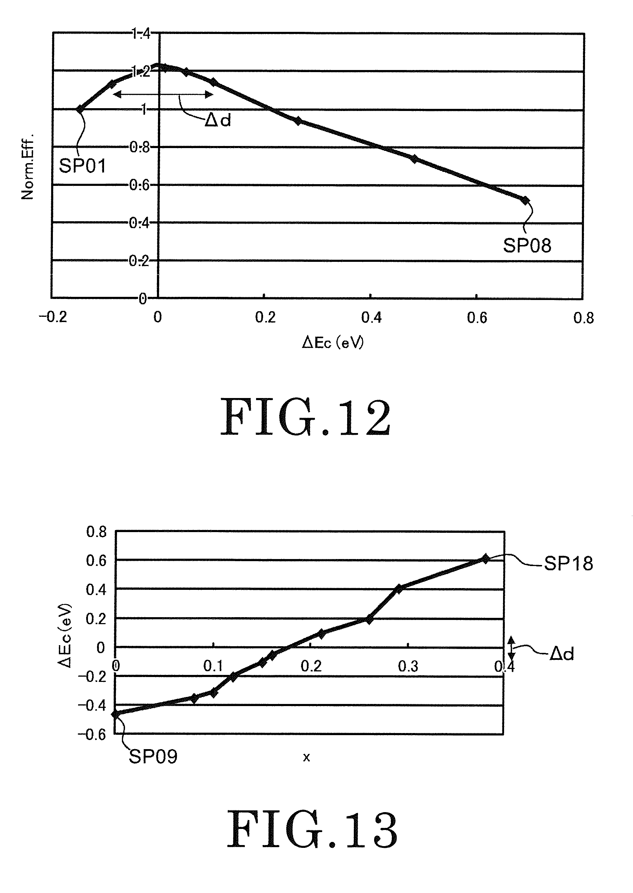

Fig.11-12 are graphs showing characteristics of the first-eighth electrode samples SP01-08. A horizontal axis in Fig.11 is a composition ratio x of Mg in the first-eighth electrode samples SP01-08. A vertical axis is a band offset ΔEc in the first-eighth electrode samples SP01-08. A horizontal axis in Fig.12 is a band offset ΔEc and a vertical axis is a conversion efficiency norm.Eff after the normalization. A range Δd, in which the absolute value is not more than 0.1 eV, is demonstrated in Figs.11-12.

As shown in Fig.11, in a case of the first electrode sample SP01, the composition ratio x of Mg being zero, ΔEc is -0.15eV. In a case of the second electrode sample, the composition ratio x of 0.03, ΔEc is -0.09eV. In a case of the fifth electrode sample, composition ratio x of 0.12, ΔEc is 0.10eV. In a case of the third and the fourth electrode samples, the composition ratio x being between those of the second electrode sample and that of the fifth electrode sample, ΔEc is not more than 0.10eV. In a case of the sixth-eighth electrode samples SP06-08, the composition ratio x being larger than that of the fifth electrode sample SP05, ΔEc is larger than 0.1eV.

As shown in Fig.12, in a case of the second-five electrodes SP02-05, the absolute value of ΔEc being not more than 0.1eV, conversion efficiency (Norm.Eff) is improved as compared to the first electrode sample SP01 being composition ratio of Mg being zero.

The composition ratio x of Mg in the first electrode 10 with $(Zn_{1-x}Mg_x)_{1-y}Al_yO$ is set to be 0.03 ≦ x ≦ 0.12eV to obtain high conversion efficiency. In this case, the optical absorption layer 30 with a band gap 1.1eV is also employed.

Characteristics of the first comparative sample are an open voltage Voc of 0.58V, short-cut current density Jsc of 34.9 mA/cm$^2$, a fill factor FF of 0.68, a conversion efficiency Eff of 13.73%. Accordingly, each of the first-eighth electrode samples SP01-08 can obtain high conversion efficiency as compared to the first reference sample with the hetero junction between the optical absorption layer 122 and the buffer later 123.

Characteristics of the second comparative sample are an open voltage Voc of 0.65V, short-circuit current density Jsc of 35.9 mA/cm$^2$, a fill factor FF of 0.76, a conversion efficiency Eff of 17.73%. Accordingly, the second comparative sample having the intermediate layer 40 can also obtain high conversion efficiency as compared to the second reference sample.

Next, characteristics of ninth-eighteenth electrode samples SP09-18 as demonstrated in Table.4 is described.

[TABLE.4]

|  | x | ΔEc(eV) | Voc (V) | Jsc (mA/cm$^2$) | FF | Eff. (%) | Norm. Voc | Norm. Jsc | Norm. FF | Norm. Eff. |
|---|---|---|---|---|---|---|---|---|---|---|
| SP09 | 0.00 | -0.46 | 0.60 | 30.0 | 0.70 | 12.60 | 1.00 | 1.00 | 1.00 | 1.00 |
| SP10 | 0.08 | -0.35 | 0.61 | 30.5 | 0.73 | 13.58 | 1.02 | 1.02 | 1.04 | 1.08 |
| SP11 | 0.10 | -0.31 | 0.61 | 30.0 | 0.74 | 13.54 | 1.02 | 1.00 | 1.06 | 1.07 |
| SP12 | 0.12 | -0.20 | 0.66 | 30.4 | 0.71 | 14.25 | 1.10 | 1.01 | 1.01 | 1.13 |
| SP13 | 0.15 | -0.10 | 0.66 | 30.5 | 0.74 | 14.90 | 1.10 | 1.02 | 1.06 | 1.18 |
| SP14 | 0.16 | -0.05 | 0.67 | 29.8 | 0.74 | 14.77 | 1.12 | 0.99 | 1.06 | 1.17 |
| SP15 | 0.21 | 0.10 | 0.67 | 29.5 | 0.75 | 14.82 | 1.12 | 0.98 | 1.07 | 1.18 |
| SP16 | 0.26 | 0.20 | 0.65 | 29.1 | 0.70 | 13.24 | 1.08 | 0.97 | 1.00 | 1.05 |
| SP17 | 0.29 | 0.41 | 0.64 | 29.0 | 0.60 | 11.14 | 1.07 | 0.97 | 0.86 | 0.88 |
| SP18 | 0.38 | 0.62 | 0.50 | 20.2 | 0.55 | 5.56 | 0.83 | 0.67 | 0.79 | 0.44 |

The ninth-eighteenth electrode samples SP09-18 are the same as the first-eighth electrode samples SP01-08 other than a band gap of the p-type portion 31 of 1.4eV. Values of ΔEc, Voc, Jsc, FF and Eff of the ninth-eighteenth electrode samples SP09-18 and values of those after normalization are demonstrated in Table.4.

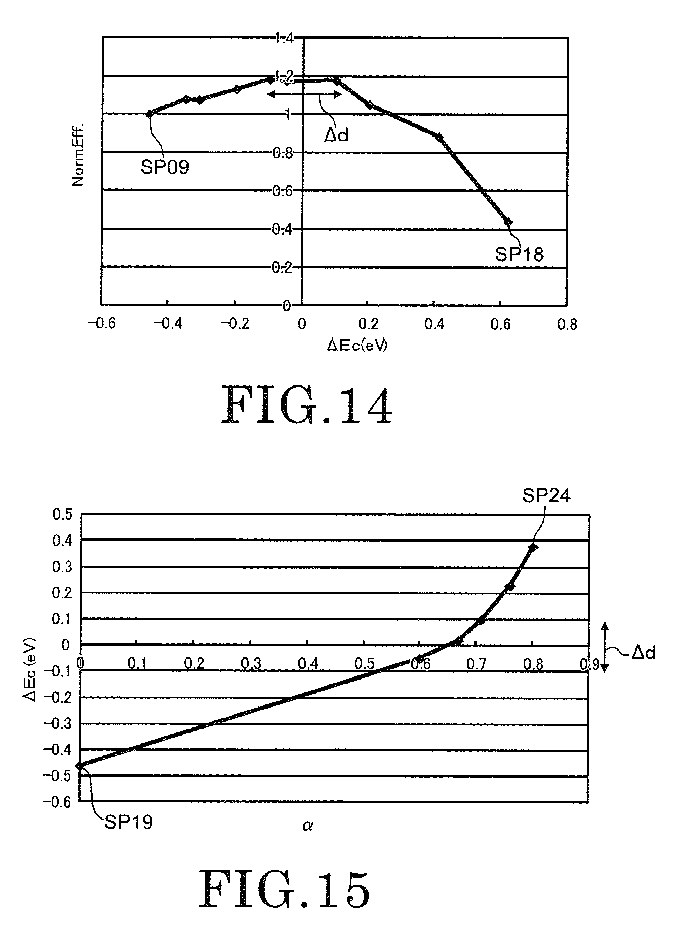

Figs.13, 14 are graphs showing characteristics of the ninth-eighteenth electrode samples SP09-SP18. A horizontal axis of Fig.13 is a composition ratio x of Mg and a vertical axis is a band off-set ΔEc. A horizontal axis of Fig.14 is the band off-set ΔEc and a vertical axis is a conversion efficiency Norm.Eff.

As shown in Fig.13, in a case of the thirteenth electrode sample SP13, the composition ratio x of Mg being 0.15 and ΔEc is -0.1eV. In a case of the ninth-twelfth electrode samples SP09-SP12, the composition ratio x is smaller than 0.15 and ΔEc is smaller than - 0.1eV. In a case of the fourteenth electrode sample SP14, the composition ratio x of, ΔEc is -0.05eV. In a case of the fifteenth electrode sample SP15, the composition ratio x of 0.21, ΔEc is 0.1eV. In a case of the sixteenth-eighteenth electrode samples SP16-18, the composition ratio x is higher than 0.21 and ΔEc is larger than 0.1eV.

As shown in Fig.14, in a case of the thirteenth-fifteenth electrode samples SP13-15, the absolute value of ΔEc being not more than 0.1 and conversion efficiency Norm.Eff is improved as compared to the ninth electrode sample SP09 when the composition ratio x of Mg is zero. The composition ratio x of the first electrode 10 with $(Zn_{1-x}Mg_x)_{1-y}Al_yO$

is set to be $0.15 \leqq x \leqq 0.21$ to obtain high conversion efficiency. In this case, the optical absorption layer 30 with a band gap of 1.4eV is also employed. Further, a dopant concentration such as Mg, Al or the like, which is composition ratio x, y, is measured by ICP ( Inductively Coupled Plasma), for example.

Next, characteristics of nineteenth-twenty-fourth electrode samples SP19-24 as shown in Table 5 are explained.

[TABLE.5]

|  | $\alpha$ | $\Delta$Ec(eV) | Voc (V) | Jsc (mA/cm$^2$) | FF | Eff. (%) | Norm. Voc | Norm. Jsc | Norm. FF | Norm. Eff. |
|---|---|---|---|---|---|---|---|---|---|---|
| SP19 | 0.00 | -0.46 | 0.60 | 30.0 | 0.70 | 12.60 | 1.00 | 1.00 | 1.00 | 1.00 |
| SP20 | 0.60 | -0.05 | 0.64 | 30.5 | 0.75 | 14.64 | 1.07 | 1.02 | 1.07 | 1.16 |
| SP21 | 0.67 | 0.02 | 0.65 | 31.0 | 0.77 | 15.52 | 1.08 | 1.03 | 1.10 | 1.23 |
| SP22 | 0.71 | 0.10 | 0.66 | 31.2 | 0.76 | 15.65 | 1.10 | 1.04 | 1.09 | 1.24 |
| SP23 | 0.76 | 0.23 | 0.65 | 29.8 | 0.71 | 13.75 | 1.08 | 0.99 | 1.01 | 1.09 |
| SP24 | 0.80 | 0.38 | 0.65 | 24.5 | 0.66 | 10.51 | 1.08 | 0.82 | 0.94 | 0.83 |

$Zn_{1-ß}Al_ßO_{1-\alpha}S_\alpha$ is employed as the first electrode 10 in the nineteenth - twenty-fourth electrode samples SP19-24. A band gap of the p-type portion 31 is set to be 1.4eV in the first electrode 10. Carrier impurities are doped into a first compound corresponding to the composition ratio $\alpha$. A composition ratio 6 is coordinated in a range from 0.01 to 0.05 to suppress an extreme decrease of mobility. The nineteenth - twenty-fourth electrode samples SP19-24 are the same as the first-eighth electrode samples SP01-08 other than a material of the first electrode 10 and the band gap of the p-type portion 31. Values of $\Delta$Ec, Voc, Jsc, FF and Eff and values of those after the normalization according to the nineteenth - twenty-fourth electrode samples SP19-24 in TABLE 5.

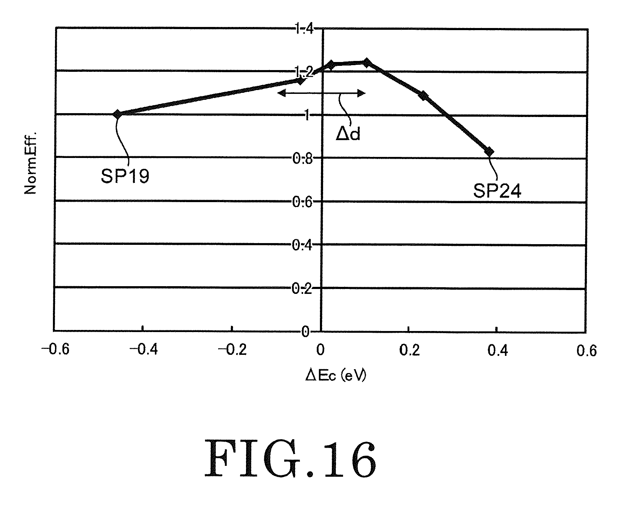

Figs.15, 16 are graphs showing characteristics of the nineteenth - twenty-fourth electrode samples SP19-SP24. A horizontal axis is a composition ratio $\alpha$ of Mg and a vertical axis is a band off-set $\Delta$Ec in Fig.15. A horizontal axis is the band off-set $\Delta$Ec and a vertical axis is a conversion efficiency Norm.Eff in Fig.16.

As shown in Fig.15, in a case of the nineteenth electrode sample SP19, the composition ratio $\alpha$ of S being zero, $\Delta$Ec is -0.46eV. In a case of the twentieth electrode sample SP20, the composition ratio $\alpha$ of S being 0.6, $\Delta$Ec is -0.05eV. In a case of the twenty-first electrode sample SP21, the composition ratio $\alpha$ of S being 0.67, $\Delta$Ec is 0.02eV. In a case of the twenty-second electrode sample SP22, the composition ratio $\alpha$ of S being 0.71, $\Delta$Ec is 0.1eV. In a case of the twenty-third electrode sample SP23, the composition ratio $\alpha$ of S being 0.76, $\Delta$Ec is 0.23eV. In a case of the twenty-fourth electrode sample SP24, the composition ratio $\alpha$ of S being 0.8, $\Delta$Ec is 0.38eV.

As shown in Fig.16, in a case of the twentieth - twenty-second electrode samples SP20-22, the absolute value of $\Delta$Ec being not more than 0.1eV, conversion efficiency is improved as compared to the nineteenth electrode sample SP19, the composition ratio $\alpha$ of S being zero. The composition ratio $\alpha$ of S is set to be $0.6 \leqq \alpha \leqq 0.71$ in the first electrode 10 of $Zn_{1-ß}Al_ßO_{1-\alpha}S_\alpha$, higher conversion efficiency can be obtained. In this case, the optical absorption layer 30 has a band gap 1.4eV.

In the embodiment, the composition ratio x of Mg is set to be in a range of $0.03 \leqq x \leqq 0.21$ to obtain high conversion efficiency in characteristics of the first-eighth electrode samples SP01-08 and the ninth-eighteenth electrode samples SP09-18. The suitable composition ratio x of Mg is changed due to the composition of the optical absorption layer 30. When a material having smaller electronic affinity such as $CuInTe_2$ is employed, the suitable composition ratio x of Mg is nearly 0.4 (specifically $0.03 \leqq x \leqq 0.4$). When a composition ratio x of Mg is $0.03 \leqq x \leqq 0.4$, the suitable composition ratio y of Mg is $0.005 \leqq y \leqq 0.2$.

As described above, the conversion efficiency in the photoelectric conversion element and the solar cell 120 including the photoelectric conversion element according to the fifth embodiment is improved by suitably setting the dopant of the n-type portion 32 of the CIGS system. Furthermore, a material of the first electrode is suitably set and energy levels of CBM and VBM of the first electrode 10 and optical absorption layer 30 are coordinated, so that conversion efficiency in a photoelectric conversion element and a solar cell having the photoelectric conversion element can be improved according to the fifth embodiment.

In this embodiment, the solar cell 120 of a surface irradiation type is explained as an example. In the solar cell 120, the photoelectric conversion element is provided on the substrate 50.

In other words, the second electrode is contacted to the substrate 50 in the solar cell 120 according to the embodiment. However, the solar cell is not restricted to the case mentioned above. A solar cell of a back surface irradiation type can be available. In the solar cell of the back surface irradiation type, a photoelectric conversion element is provided under a substrate. In other words, the first electrode 10 can be contacted to the substrate 50 in the solar cell of the back surface irradiation type.

A compound semiconductor having a chalcopyrite structure is employed as the optical absorption layer 30 according to each of the embodiments. A compound semiconductor having a stannite structure which is near the compound semiconductor having the chalcopyrite structure can be employed as the optical absorption layer 30 other than the compound semiconductor having the chalcopyrite structure. $Cu_2(SnZn)S_4$ is nominated as the compound semiconductor having the stannite structure, for example.

Both a photoelectric conversion element and a solar cell having improved conversion efficiency are provided according to the embodiments

The embodiments are described by referring with specific examples. However, embodiments are not restricted to the specific examples. A specific constitution of each element of a first electrode, a second electrode, an optical absorption layer, a p-type portion, an n-type portion, an intermediate layer, a substrate, a first terminal and second terminal included in a photoelectric conversion element and a solar cell can be suitably selected from in a range of a person skilled in the art. The constitution is included in this invention as long as the constitution is performed as the same as the embodiments to obtain the same effect in this invention. Furthermore, a constitution combined two or more elements in each of specific examples within a range technologically available is also included in this invention as long as the constitution includes the gist of this invention.

In others, all of the photoelectric conversion element and the solar cell which can be perform with suitably changing a design by a person skilled in the art based on the photoelectric conversion element and the solar cell described above as the embodiments, are also included in the range of this invention as long as the photoelectric conversion element and the solar cell belong to the gist of this invention.

In others, a person skilled in the art can conceive of kinds of modifications and revisions in a category of thought of the invention, and the modification examples and the revision examples are understood to be included in the range of this invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A photoelectric conversion element, comprising:

   a first electrode having optical transparency;
   a second electrode; and
   an optical absorption layer provided between the first electrode and the second electrode, the optical absorption layer having a compound semiconductor constituted with a chalcopyrite structure or a stannite structure, the compound semiconductor having a first element of a Group 11 element and a second element of a Group 16 element and comprising a p-type portion and an n-type portion provided between the p-type portion and the first electrode, the n-type portion and the p-type portion jointly having a homo junction;
   wherein the n-type portion comprises a dopant which has a formal charge $V_b$ being not less than 1.60 and not more than 2.83 and being represented by a Formula (1),

$$V_b = \sum_{j=1}^{n} \exp\left(\frac{r_0 - r_i}{B_f}\right) \quad \cdots \quad (1)$$

   where a bond length between the first element and the second element is $r_i$ angstrom when the first element is substituted with the dopant, a bond parameter between the first element and the second element is $r_0$ angstrom, an identification number determined by a combination between the first element and the second element is $B_f$ angstrom, a number of neighboring bonds of the second element to the first element is n which is an integer and not less than one.

2. The photoelectric conversion element of Claim 1, wherein the formal charge $V_b$ is not less than 1.83 and not more than 2.83.

3. The photoelectric conversion element of Claim 1, wherein the dopant includes at least one of Mg, Zn, Fe, and Co.

4. The photoelectric conversion element of Claim 1, wherein
the second element is one element selected from O, S, Se and Te, and the compound semiconductor further comprises at least one Group 13 element selected from Al, In and Ga.

5. The photoelectric conversion element of Claim 4, wherein
The first element is Cu or Ag and the second element is Se or S.

6. The photoelectric conversion element of Claim 1, wherein
the compound semiconductor comprises $X_\varepsilon(In_{1-\gamma}Ga_\gamma)_\sigma(Se_{1-\varphi}S_\varphi)_\psi$ where X, $\varepsilon$, $\sigma$ and $\psi$ are designated as Ag or Cu, $0.6 \leqq \varepsilon \leqq 1.1$, $0.8 \leqq \sigma \leqq 1.2$ and $1.5 \leqq \psi \leqq 2.5$, respectively, and both y and ($\varphi$ are arbitrary constants.

7. The photoelectric conversion element of Claim 1, wherein
the first electrode comprises a first compound comprising at least one selected from $(Zn_{1-x}Mg_x)_{1-y}M_yO$ and $Zn_{1-\text{ß}}M_\text{ß}O_{i-\alpha}S_\alpha$, where M is at least one element selected from B, Al, Ga and In, and x, y, $\alpha$ and ß are designated as $0.03 \leqq x \leqq 0.4$, $0.005 \leqq y \leqq 0.2$, $0.4 \leqq \alpha \leqq 0.9$ and $0.005 \leqq \text{ß} \leqq 0.2$, respectively;

8. The photoelectric conversion element of Claim 7, wherein
the optical absorption layer further comprises an intermediate layer provided between the first electrode and the n-type portion, the intermediate layer having a higher electrical resistance than an electrical resistance of the first electrode, the intermediate layer comprising a second compound which comprises at least one selected from $(Zn_{1-x}Mg_x)_{1-y}M_yO$ and $Zn_{1-\text{ß}}M_\text{ß}O_{1-\alpha}S_\alpha$, where both y and ß are less than 0.005.

9. The photoelectric conversion element of Claim 1, wherein
an absolute value of difference of an electronic affinity between the optical absorption layer and the first electrode is not more than 0.1eV.

10. A solar cell comprising:

the photoelectric conversion element according to Claim 1;
a substrate on which the photoelectric conversion element is stacked;
a first terminal electrically connected to the first electrode; and
a second terminal electrically connected to the second electrode.

FIG.1

FIG.2

FIG.3

FIG.4A

FIG.4B

FIG.4C

FIG.4D

START

FORMING SECOND ELECTRODE ⎯ S1

FORMING P-TYPE LAYER ⎯ S2

IMMERSING SUBSTRATE IN SOLUTION ⎯ S3A ⎱
ADDING DOPANT IN SOLUTION ⎯ S3B
⎰ S3
CLEANING SUBSTRATE ⎯ S3C
DRYING SUBSTRATE ⎯ S3D ⎰

FORMING FIRST ELECTRODE ⎯ S4

FORMING FIRST TERMINAL ⎯ S5

FORMING SECOND TERMINAL ⎯ S6

FORMING ANTI-REFLECTING FILM ⎯ S7

END

# FIG.5

FIG.6

FIG.7

FIG.8A

FIG.8B

# FIG.9A

# FIG.9D

# FIG.9B

# FIG.9E

# FIG.9C

# FIG.9F

## FIG.10

## FIG.11

# FIG.12

# FIG.13

FIG.14

FIG.15

# FIG.16

## INTERNATIONAL SEARCH REPORT

| | International application No. |
|---|---|
| | PCT/JP2012/007227 |

A. CLASSIFICATION OF SUBJECT MATTER
*H01L31/068*(2012.01)i, *H01L31/032*(2006.01)i, *H01L31/0224*(2006.01)i

According to International Patent Classification (IPC) or to both national classification and IPC

B. FIELDS SEARCHED

Minimum documentation searched (classification system followed by classification symbols)
H01L31/04-31/078, H01L31/032, H01L31/0224

| Documentation searched other than minimum documentation to the extent that such documents are included in the fields searched | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
JSTPlus/JMEDPlus/JST7580(JDreamII), CiNii

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-015039 A (Honda Motor Co., Ltd.),<br>15 January 2004 (15.01.2004),<br>entire text; all drawings<br>(Family: none) | 1-6,10<br>7-9 |
| X<br>Y | JP 2011-159651 A (Fujifilm Corp.),<br>18 August 2011 (18.08.2011),<br>entire text; all drawings<br>& JP 4611447 B     & EP 2352172 A2<br>& CN 102157615 A | 1-6,10<br>7-9 |
| X<br>Y | JP 2005-228975 A (Matsushita Electric<br>Industrial Co., Ltd.),<br>25 August 2005 (25.08.2005),<br>entire text; all drawings<br>(Family: none) | 1-6,10<br>7-9 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 18 January, 2013 (18.01.13) | 29 January, 2013 (29.01.13) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

| | International application No. |
|---|---|
| | PCT/JP2012/007227 |

C (Continuation).  DOCUMENTS CONSIDERED TO BE RELEVANT

| Category* | Citation of document, with indication, where appropriate, of the relevant passages | Relevant to claim No. |
|---|---|---|
| X<br>Y | JP 2008-235794 A  (Tokyo University of Science),<br>02 October 2008 (02.10.2008),<br>entire text; all drawings<br>(Family: none) | 1-6,10<br>7-9 |
| X<br>Y | WO 2011/136249 A1  (Kyocera Corp.),<br>03 November 2011 (03.11.2011),<br>entire text; all drawings<br>(Family: none) | 1-6,10<br>7-9 |
| X<br>Y | WO 1999/017377 A1  (MIDWEST RESEARCH INSTITUTE),<br>08 April 1999 (08.04.1999),<br>entire text; all drawings<br>& US 5948176 A          & AU 9498798 A | 1-6,10<br>7-9 |
| Y | JP 2004-158619 A  (Matsushita Electric<br>Industrial Co., Ltd.),<br>03 June 2004 (03.06.2004),<br>paragraphs [0023] to [0026], [0036] to [0037]<br>& US 2004/0089874 A1    & DE 10351674 A<br>& CN 1499649 A | 7-9 |
| Y | JP 2004-214300 A  (National Institute of<br>Advanced Industrial Science and Technology),<br>29 July 2004 (29.07.2004),<br>claim 11; paragraphs [0019] to [0020]<br>(Family: none) | 7,9 |
| Y | WO 2009/069582 A1  (Showa Shell Sekiyu<br>Kabushiki Kaisha),<br>04 June 2009 (04.06.2009),<br>paragraph [0045]<br>& JP 2009-135337 A      & US 2010/0267190 A1<br>& DE 112008003144 T | 8-9 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BROWN ; ALTERMATT.** *Acta Cryst.,* 1985, vol. B41, 244